# EUROPEAN PATENT SPECIFICATION

(11) **EP 1 181 570 B1**
(45) Date of publication and mention of the grant of the patent: **22.11.2006**
(21) Application number: 00935306.1
(22) Date of filing: 22.05.2000
(51) Int. Cl.: G01R 33/28

(54) **METHOD OF MAGNETIC RESONANCE IMAGING**
VERFAHREN ZUR BILDERZEUGUNG DURCH MAGNETISCHE RESONANZ
PROCEDE D'IMAGERIE PAR RESONANCE MAGNETIQUE

(30) Priority: 21.05.1999 GB 9911937; 31.03.2000 GB 0007869
(43) Date of publication of application: 27.02.2002
(73) Proprietor: GE Healthcare AS, 0485 Oslo (NO)
(72) Inventor: BRILEY-SÆBO, Karen, Woodcliff Lake, NJ 07677 (US); BJORNERUD, Atle, 0765 Oslo (NO); NANZ, Daniel, 8006 Zurich (CH); WEISHAUPT, Dominik, 8006 Zurich (CH)
(74) Representative: Hammett, Audrey Grace Campbell
(86) International application number: PCT/GB2000/001963
(87) International publication number: WO 2000/072032

(56) References cited:
- EP-A- 0 754 954
- US-A- 5 479 925
- US-A- 5 609 153

## Description

The invention relates to improvements in and relating to magnetic resonance imaging (MRI), in particular to generation of magnetic resonance images of invasive devices, e.g. during surgical procedures.

During surgical and therapeutic procedures it is frequently desirable for the physician to be able to locate or guide invasive devices inserted into the body (for example catheters, guide wires, biopsy needles, etc.) when these are not directly visible to the naked eye.

Due to the reduced invasiveness of surgical procedures, MRI-guided interventional procedures have gained increasing importance in recent years. Such MRI guided procedures can be divided into two categories: intraoperative procedures which integrate surgery with MRI and interventional procedures for guiding, monitoring and controlling therapy.

Intraoperative procedures generally require an open magnet MR imager and are desirable as the MRI can be used to define anatomy and monitor tissue function as it changes during surgery. By monitoring anatomy and function in this way, the clinical outcome for the patient may be improved since complications may be reduced by reducing the degree of invasiveness of the surgery.

Interventional procedures generally require only limited patient access and thus conventional closed magnet MR imagers may be used. The high spatial and temporal resolution available in MRI allows for accurate "near real time" guidance of devices such as catheters, guide wires, biopsy needles, etc.

The success of an MRI-guided interventional or intraoperative procedure generally depends on the ability of the MRI technique to provide sufficiently accurate visualisation of the instruments and devices inserted into the patient's body. Currently, either active or passive visualisation techniques have been used for monitoring and visualising such instruments and devices (herein generally referred to as "invasive devices").

In active visualisation, the invasive device is provided with a small signal receiving antenna (e.g. on the tip of the device). The magnetic resonance signal from water protons in the vicinity of the antenna is detected by the antenna and incorporated into the MR image generated by the MR imager. The result is a "road map" showing the movement of the antenna (and hence the device) within the patient. There are however two problems associated with active visualisation. Firstly, heat generated within the antenna may be large if large magnetic field gradients or rapid gradient switching are used in the MRI procedure. Secondly, since the signal from the device is superimposed over the original MR image, any tissue movement may result in loss in accuracy of spatial information regarding device location.

The term "passive visualisation" is used to describe the case where device visualisation relies on a difference in magnetic susceptibility between the material from which the device is made and the surrounding biological tissue or fluid. In order to increase this susceptibility difference, it has been conventional to mark the device with a magnetic (i.e. paramagnetic, ferrimagnetic, ferromagnetic or superparamagnetic) material, such as for example dysprosium oxide (Dy₂O₃). To avoid extensive marking resulting in blurring artefacts in the MR images, it has been common to incorporate small bands or rings of Dy₂O₃ or of a material containing for example 10% w/w Dy₂O₃. *In vitro* studies have shown that such Dy₂O₃-marked devices can be visualised accurately in "near real time" imaging procedures without causing significant image artefacts (such as for example blurring or distortion) as long as the device is parallel to the primary magnetic field of the MR imager. Where the device is perpendicular to the primary field however, blurring and distortion artefacts occur which result in over-estimation of device size and decrease in spatial resolution.

US-5 609 153 A describes a passive visualization technique wherein a contrast enhancing, e.g. a physiological solution, fluid is passed through a separate prepolarizing high-field magnet. The prepolarized, contrast enhancing fluid is the introduced into the subject via the catheter. The prepolarizing magnet adds an additional, expensive component to the MRI apparatus.

Biopsy needles are currently monitored using passive visualisation; however the needles currently used produce severe image artefacts which distort the observed size and location of the needles. To compensate for this, two techniques have been developed. Firstly a laser guidance system may be used to guide the needle to the target tissue; however, using this technique, it is still difficult to determine needle depth within the tissue. Accordingly, needles have been produced which have a small inner bore at the needle tip. This is filled with a gadolinium chelate solution (e.g. a solution of Gd DTPA, Gd DTPA-bismethylamide or Gd HP-DO3A) which allows for visualisation of the needle tip in the MR image. However the gadolinium chelates used distribute rapidly into the extravasular space and thus even with single or multiple injections of the gadolinium chelate solution only temporary assistance in passive visualisation of the needle tip is achieved.

The present invention is directed to facilitating passive visualisation of invasive devices and relies instead on introducing into the vasculature a chemical blood pool MR agent, i.e. an MR contrast agent which does not distribute into the extravasular space but instead remains substantially in the intravascular space during the time course of the visualisation procedure. The effect of the contrast agent is to enhance the relaxation properties of the blood (i.e. to reduce T₁ and/or T₂* for blood) relative to those of the invasive device. Thus, using the invention, the invasive devices traditionally utilised in intraoperative and interventional MRI can be used.

Thus viewed from one aspect the invention provides a method of facilitating passive visualisation of an invasive device in the vasculature of a human or non-human body or in vascularised tissue in said body by generating an MR image of at least part of said body containing said device and containing a chemical blood pool contrast agent, wherein said blood pool contrast agent has been selected so as to remain in the intravasular space during the time course of the visualisation procedure.

By a chemical blood pool MR contrast agent is meant a magnetic (e.g. paramagnetic, ferromagnetic, ferrimagnetic or superparamagnetic) material capable of reducing the T₁ and/or T₂* of water protons and which if administered into the vascular space does not significantly leak out into the interstitium during the time course of the interventional or intraoperative procedure, i.e. it is essentially confined to the vascular space until excreted or metabolized. Examples of such blood pool agents include polymeric chelates (e.g. cascade polymers or dendrimers carrying metallated chelate groups) and particulates, in particular iron oxides and liposomes. Generally the agent should have a blood half life of at least 5 minutes, preferably at least 30 minutes. By way of contrast, the first parenteral MR contrast agents Gd DTPA (Magnevist® from Schering), Gd DTPA-bismethylamide (Omniscan® from Nycomed Amersham) and Gd HP-D03A (ProHance®) are all extracellular fluid MR agents; they are water-soluble mono-chelates which following administration into the vasculature rapidly extravasate into the interstitium.

Chemical blood pool agents of particular use in the method of this invention include low molecular weight chelates which bind to blood proteins, e.g. blood proteins such as albumin, for example DTPA or DOTA derivatised with protein binding groups, e.g. lipophilic side chains such as aromatic moieties, e.g. one or more phenyl ring systems. One such example is MS-325/Angiomark of EPIX.

Suitable polymer based contrast agents for use in the method of the present invention can be carbohydrate or protein based, e.g. CMD-DTPA-Gd of Guerbet (Carboxymethyl dextran-GdDTPA conjugates), GdDTPA polylysine conjugates, or cascade or dendrimer polymers, e.g. Gadomer 17 of Schering AG or similar cascade polymers as described in US-A-5874061 (of Schering AG).

Suitable iron oxide (or doped iron oxide) based contrast agents for use in the method of the present invention are known in the field under the name of SPIO (superparamagnetic iron oxides) or USPIO (ultrasmall superparamagnetic iron oxides). Examples include carbohydrate stabilised iron oxide particles, e.g. dextran-stabilised particles such as Combidex of Advanced Magnetics, and NC100150 (Clariscan, Nycomed Amersham).

More particularly the magnetic iron oxide contrast agent is preferably a water-dispersible material comprising magnetic iron oxide particles having on their surfaces (e.g. as a coating), an optionally modified carbohydrate or polysaccharide or derivative thereof, e.g. a glucose unit containing optionally modified polysaccharide or derivative thereof, preferably an optionally modified dextran or starch or derivative thereof, for example a cleaved (e.g. oxidatively cleaved) starch or carboxylated dextran. Such iron oxide complexes preferably also comprise a further material (e.g. coating material), especially one which inhibits opsonization, e.g. a hydrophilic polymer, preferably a functionalized polyalkylene oxide, more preferably a functionalized polyethylene glycol (PEG), in particular methoxy PEG phosphate (MPP).

The iron oxide complexes preferably have a core (i.e. iron oxide particle) diameter (mode diameter) of 1 to 15 nm, more preferably 2-10 nm, especially 3-7 nm, a total diameter (mode particle size) of 1 to 100 nm, more preferably 5-50 nm, especially preferably 10-25 nm, an r₂/r₁ ratio at 0.47T and 40°C of less than 3, more preferably less than 2.3, still more preferably less than 2.0, especially preferably less than 1.8. The saturation magnetization (Msat) at 1T is preferably 10 to 100 emu/gFe, more preferably 30-90 emu/gFe.

Other particulate based systems of use in the method of the present invention include liposomal or emulsion based agents.

Furthermore, compound 7228 of Advanced Magnetics can be used in the method of the present invention, as can the materials described in WO 91/12025, WO 90/01899, WO 88/00060, WO 91/12526 and WO 95/05669, all to Advanced Magnetics, and those described in WO92/11037 and WO90/01295.

Using chemical blood pool MR contrast agents which remain in the vascular space during the MRI-guided procedure allows for extensive monitoring of the invasive device during the procedure. The method of the invention, an "induced passive visualisation" technique, not only allows visualisation of static devices, such as stents, but also can be used to guide placement of devices, e.g. it can be used in ablation therapy to mark vessels and/or aid in the placement of the ablation device.

Currently, three types of ablation procedures are in use clinically: interstitial laser-induced thermotherapy (LITT); focussed ultrasound; and rf-ablation.

LITT is used for the destruction of local tumors in solid organs - laser light is delivered to the tumor through optical fibres and tumor destruction occurs by direct heating by the laser light. The optical fibre is introduced in MRI-guided procedures using an MRI-guided catheter; induced passive visualisation according to the invention will allow accurate visualisation of the catheter and ensure correct placement of the optical fibre tip.

During MRI-guided focussed ultrasound ablation therapy, an ultrasound transducer is moved hydraulically across the patient and the depth and position of the ultrasound focus are determined by laser optical fibres which are locked onto target from an MR image. Induced passive visualisation according to the invention will assist by increasing the accuracy of the focus positioning since the technique allows for monitoring of all major vessels surrounding the tumor, as well as of the tumor itself, throughout the procedure.

In rf-ablation therapy, a radiofrequency electrode is placed in tissue which has previously been injected with saline. The tissue around the electrode is then heated by applying 1500-1600 mA to the electrode. The technique is relatively non-specific since treatment regions vary in shape and are dependent on local saline concentration; induced passive visualisation according to the invention will increase specificity by allowing more accurate placement of the electrode and more accurate estimation of saline concentration. Again, both tumor and surrounding vessels may be monitored throughout the procedure.

During all intraoperative and interventional procedures, complications due to bleeding increase the risks associated with the procedures. Induced passive visualisation according to the invention however allows for accurate monitoring and assessment of bleeding during the procedure. Since the chemical blood pool MR contrast agent remains in the blood during the procedure, any damage to blood vessels that causes changes in vessel permeability can be observed.

The invasive devices which can be monitored according to the invention include, but are not limited to, catheters, balloons, optical fibres, guide wires, needles (e.g. biopsy needles), electrodes, electrode leads, implants, stents and stent graphs. Generally these devices will be diamagnetic and exhibit long T₁ values. If desired, the devices may be marked with a magnetic susceptibility agent, e.g. bands or strips containing dysprosium oxide - however such marking is not necessary and desirably is avoided. As in all MRI-guided procedures however the devices used are preferably not substantially ferromagnetic or ferrimagnetic as this will cause image defects and gradient switching may cause unwanted motion of the devices.

The MR imaging procedure used in the method of the invention may for example be any conventional MRI procedure, e.g. T₁ or T₂* weighted spin echo or gradient echo sequences. However, fast imaging procedures, such as gradient echo and echo planar imaging procedures are preferred. In a particularly preferred embodiment of the method of the invention, the imaging procedure involves administration of an iron oxide blood pool MR contrast agent, gradient echo imaging using small flip angles (e.g. 10 to 45°) and short echo times (e.g. 0.5 to 5 ms) and using larger flip angles (e.g 55 to 75°) and longer echo times (e.g. 6 to 20 ms). In the larger flip angle/longer echo time images the signal from the contrast agent containing blood is diminished and, using both images, visualisation of the invasive device may be facilitated (especially where the device contains a gadolinium chelate solution as a marker).

Viewed from another aspect the invention provides a method of facilitating passive visualisation of an invasive device in the vasculature of a human or non-human body or in vascularised tissue in said body by generating an MR image of at least part of said body containing said device and containing a chemical blood pool contrast agent, wherein said blood pool contrast agent has been selected so as to remain in the intravascular space during the time course of the visualisation procedure so that the difference in T₁ and/or T₂ and/or T₂* between the blood and said device containing a paramagnetic or diamagnetic material may be utilized to generate image contrast between blood and said device.

By containing it is meant that the device may contain the paramagnetic or diagnostic material when it is inserted or that the material may be placed in the device following its insertion.

Thus the method may involve administering a chemical blood pool contrast agent (e.g. an USPIO) into the vasculature and filling an invasive device (before or after its insertion) with a paramagnetic agent (e.g. a gadolinium chelate) and then generating an image of the vasculature using very fast, heavily T₁-weighted sequences. In this way slice position matching with the device is unnecessary. The selectivity of differentiation between blood and device is achieved by a minor increase in echo time that would not normally result in the sequence being termed non-T₁-weighted.

Viewed from a further aspect the invention also provides a method of facilitating passive visualisation of an invasive device in the vasculature of a human or non-human body or in vascularised tissue in said body by generating an MR image of at least part of said body containing said device and containing a chemical blood pool contrast agent, wherein said blood pool contrast agent has been selected so as to remain in the intravascular space during the time course of the visualisation procedure, so that the T₁ and/or T₂* of the blood is enhanced relative to that of said device, and wherein when enhancing the T₁ of the blood relative to said device, T₁-weighted sequences should be used and said device should be filled with diamagnetic material (e.g. saline or medication) so that the blood appears bright relative to said device, and wherein when enhancing the T₂* of the blood relative to the device, T₂ or T₂*-weighted sequences should be used and the device coated with or filled with paramagnetic material (e.g. Gd complex or Mn complex) so that said device appears bright relative to the blood.

By initially or subsequently containing it is meant that the device may contain the paramagnetic chelate (preferably a water-soluble Gd or Mn monochelate) when it is inserted or that the chelate may be filled into the device following insertion.

In both the methods of the invention it is desirable to use as the chemical blood pool MR contrast agent a superparamagnetic iron oxide, optionally coated with an opsonization inhibitor such as PEG, e.g. as described in WO97/25073. Such particles allow T₁ effects to predominate in heavily T₁-weighted imaging sequences - leading to an increased signal intensity for blood relative to invasive device (i.e. a "bright blood" technique) - and allow T₂* effects to predominate when T₂-weighted imaging sequences are used - leading to a decreased signal intensity for blood relative to invasive device (i.e. a "black blood" technique). Such black blood techniques are used where paramagnetic devices or devices with paramagnetic markers are used. The bright blood technique is used with diamagnetic devices which contain a diamagnetic material (e.g. saline or medication).

The dosage of the contrast agent used according to the invention will depend upon the species, the longitudinal relaxivity of the agent, the magnetic moment of the agent at the imaging field strength and the sequence parameters used to acquire the image. Desirably the chemical blood pool MR contrast agent is administered at dosages sufficient to achieve T₁ values in blood, at steady state, of less than 300 ms, more preferably less than 200 ms and still more preferably less than 100 ms.

In MR procedures in which a blood pool contrast agent is to be administered into the vasculature, this would normally be done outside the region of interest for imaging, e.g. in a peripheral vein and one would not expect images of the catheter to be generated either on contrast agent administration or on contrast agent circulation (or recirculation) past the catheter. Thus in the methods of the invention the invasive device may be a catheter used for administration of the chemical blood pool contrast agent; however more generally and preferably the invasive device will be other than a device through which the chemical blood pool contrast agent is administered.

The chemical blood pool contrast agent will preferably be administered by injection or infusion into the vasculature, for example infused over periods of 2 seconds to 5 minutes.

The chemical blood pool contrast agent will desirably be formulated in a sterile aqueous medium, optionally containing further excipients such as pH modifiers, osmolality modifiers, chelating agents, etc.

The methods of the invention will now be described further with reference to the following non-limiting Examples and the accompanying drawings, in which:
Figure 1 shows the construction of two phantoms use to study the feasibility of catheter tracking by MRI;
Figure 2 shows a bright blood image of phantoms having catheters filled with saline (top) or 10mM Omniscan (bottom) and placed perpendicular to the applied field;
Figure 3 shows a bright blood image of phantoms having catheters filled with saline (left) or 10mM Omniscan (right) and placed parallel to the applied field;
Figure 4 shows a dark blood image of a phantom having a catheter filled with 10 mM Omniscan and placed perpendicular to the applied field;
Figure 5 shows a summary of an MRI signal optimisation study conducted at TR/TE=5.0/1.5 ms (Fig 5a) and TR/TE=18.0/9.0 ms (Fig 5b) with varying flip angles and concentrations;
Figure 6 shows spoiled GRE images of phantoms collected with parameters TR/TE/FA=5.2/1.2/40° (Fig 6a) and TR/TE/FA=18/9.0/70° (Fig 6b); and;
Figure 7 shows spoiled GRE in vivo images of the abdomen of a pig collected with parameters TR/TE/FA=5.2/1.2/40° (Fig 7a) and TR/TE/FA=18/9.0/70° (Fig 7b).

An aqueous suspension superparamagnetic iron oxide MR contrast agent, prepared according to the description of Example 12 of WO 97/25073 was used in these Examples.

The characteristics of the suspension were as follows:
[Fe] = 30.2 mg Fe/ml, density = 1.0589 g/ml, r₁ = 19.3 s⁻¹mM⁻¹, r₂ = 31.2 s⁻¹mM⁻¹, r₂/r₁ = 1.61, saturation magnetisation (Msat) = 84 emu/g Fe.

### Example 1

### Phantom Study

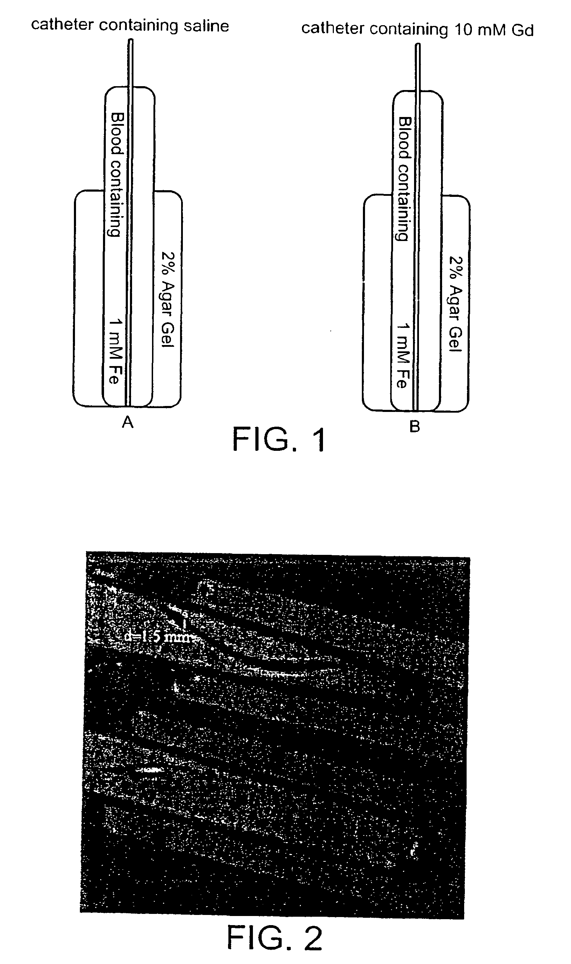

A simple *ex vivo* phantom study was performed in order to assess the feasibility of performing induced passive catheter tracking by reducing T₁ and T₂* of blood. Two phantoms were prepared by placing sections of a conventional interventional catheter (Pebax Souple 5F with inner diameter of 1.17 mm and outer diameter of 1.69 mm) into two plastic tubes of 10 mm diameter and 85 mm length inside 21 mm diameter, 60 mm length glass vials. The plastic tubes were fixed in the vial in a 2% agar gel containing gadolinium polymers (e.g. a gadolinium polychelate such as polylysinepolyDTPA.Gd) so that the T₁ of the gel at 40°C was 535 ms. The plastic tubes were filled with fresh human blood (Hct = 47%) containing sodium heparin. The iron oxide contrast medium was added to the blood so that the concentration of Fe added was 1.0 mM Fe (which is equivalent to a dose of 4 mg Fe/Kg bodyweight). One of the catheters was then filled with saline and sealed and the other catheter was filled with 10 mM Omniscan^{®} (10 mM Gd DTPA-bismethylamide) and sealed. The arrangement was as shown in Figure 1 of the accompanying drawings. All imaging was performed at 1.5 T (Philips Gyroscan ACS-NT) using T₁ and T₂-weighted 3D-gradient echo sequences (FFE). Table 1 shows the sequence parameters which were kept constant for all experiments.

**Table 1: Pulse Sequence parameters for static in vivo phantom imaging**

| Parameter | Value |
|---|---|
| TR | 15.4 ms |
| Slice thickness | 0.7 mm |
| Field of view | 140 x 140 |
| Nmat | 256 x 256 |
| NEX | 2 |
| Flip angle | 30° |

The following two imaging series were performed on the phantoms:
Series 1: Phantoms placed perpendicular relative to the applied field. Images were acquired at echo times (TE) of 2 ms (for bright blood) and 12 ms (for black blood).
   The phantoms were removed from the magnet and inverted several times to ensure the homogeneity of the blood samples prior to the on set of imaging Series 2.
Series 2: Phantoms placed parallel relative to the applied magnetic field. Images were acquired using a TE of 2 ms so that bright blood was obtained.

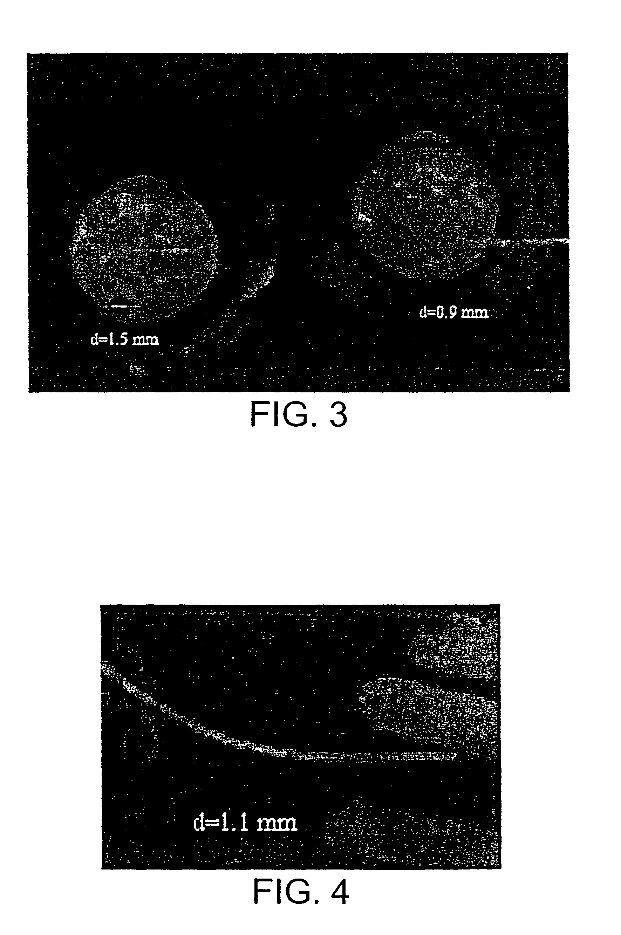

Figures 2, 3 and 4 of the accompanying drawings show the results obtained when either the T₁ (bright blood obtained using short echo times) or T₂* (dark blood obtained using long echo times) of the blood is reduced relative to the device. In Figures 2 and 4 the phantoms were placed perpendicular relative to the applied magnetic field and Figure 3 shows the phantom placed parallel relative to the applied field. In Figures 2 and 3, short echo times were used so that the T₁ of the blood was reduced relative to that of the catheters. Figure 2 shows the phantoms placed perpendicular to the applied field. The catheters were filled with either saline (top) and 10 mM Gd DTPA-BMA (bottom). In Figure 3, the phantoms were placed parallel to the applied magnetic field and the catheter containing the saline is shown to the left and the catheter containing the Gd DTPA-BMA is shown to the right. The diameter shown in these figures represents the total catheter diameter estimated by MRI. The actual catheter diameter for all phantoms was 1.69 mm.

The catheter filled with saline represents a conventional interventional catheter. The catheter filled with 10 mM Omniscan^{®} represents an MRI catheter containing a paramagnetic tracer. The results clearly indicate the size of the catheter (total diameter) was underestimated when the catheter was filled with 10 mM Omniscan^{®}. However, when the catheters were filled with saline (which represents a normal interventional procedure) fairly accurate estimates of size were obtained. The under-estimation of size observed when using a paramagnetic tracer is most likely due to the fact that the wall of the catheter has very few protons and consequently is not MR-visible. This means that the signal coming from the outer wall of the catheter is dark relative to the signal inside the catheter (which contains 10 mM Gd) and signal of the blood (which contains the iron oxide contrast medium). As a result, the size reflects only the inner-diameter of the catheter. However, when saline is used, a homogeneous dark signal is observed which accurately reflects catheter size. This is due to the fact that the catheter and the saline filling the catheter both appear hypointense relative to the blood containing the iron oxide contrast medium (bright blood obtained using short echo times).

No artefacts were observed for either phantom in any orientation relative to the applied field.

Figure 4 shows the results obtained when the T₂* of the blood is reduced relative to that of the device by increasing the echo times used. Here the blood appears black since the reduction of T₂* dominates the observed signal. For "black blood", only the catheter filled with 10 mM Gd (representing the paramagnetic tracer catheter) is visible. The diameter shown represents the diameter estimated by MRI. The actual diameter was 1.69 mm. The phantom was placed perpendicular relative to the main field. The size of the catheter obtained by MR still reflects only the inner-diameter.

### Example 2

Example 2 summarises a study performed in order to determine the optimal imaging sequence parameters required for passive induced visualisation when black blood techniques are employed (catheter filled with a paramagnetic tracer, blood containing the iron oxide contrast medium and long echo times used to enhance the T₂* of the blood relative to the catheter).

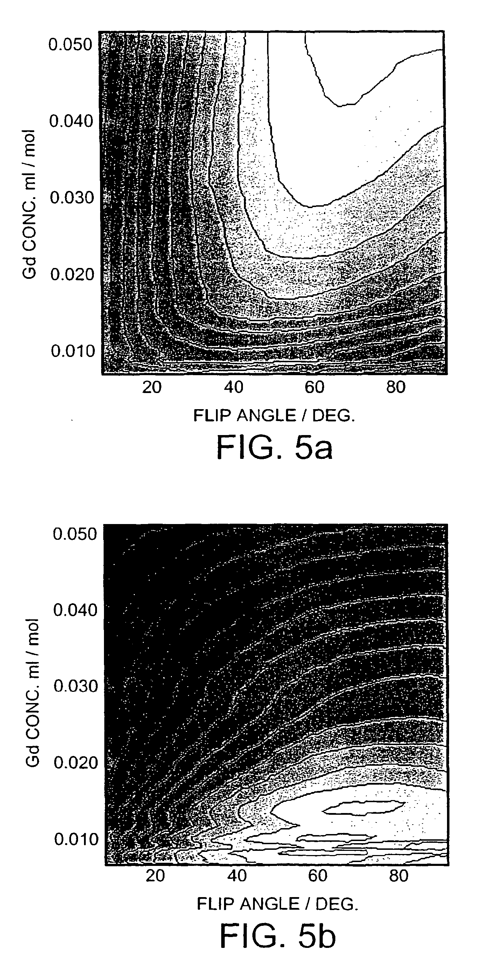

Figures 5A (TR/TE=5.0/1.5 ms) and 5B (TR/TE=18.0/9.0 ms) show experimental signal-intensity profiles of diluted Gd solutions as a function of concentration and flip angle. Brighter zones correspond to higher signal intensity. Note the shift of the signal maximum towards lower concentrations for longer echo times.

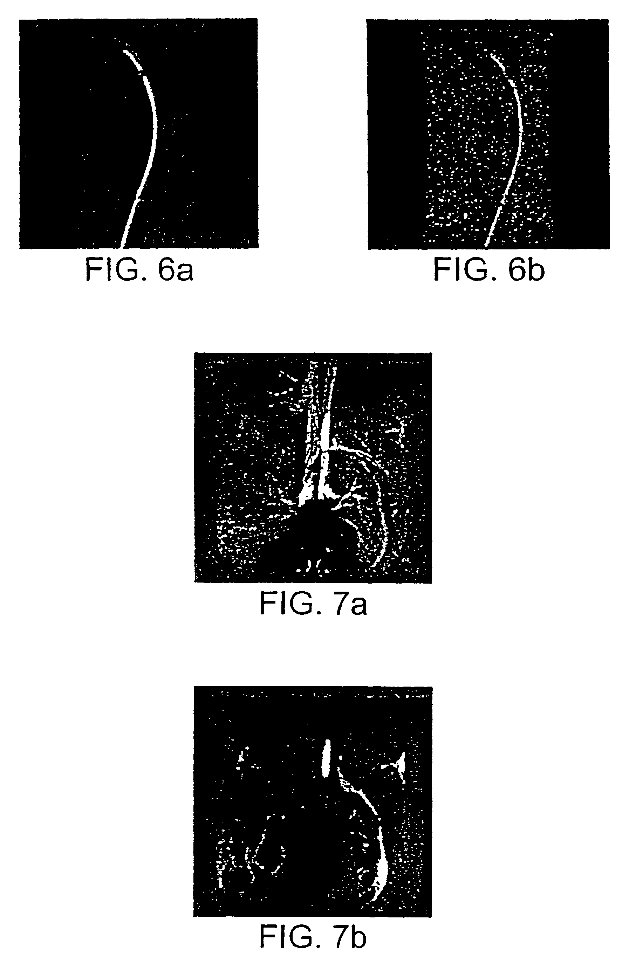

A catheter (0.8 mm inner diameter) with an Omniscan^{®}/H₂O (0.01 M) filled guide-wire lumen was inserted into a flexible tube (i.d. 5 mm) filled with the iron oxide contrast medium (0.5 mg Fe/ml). Spoiled 2D and 3D GRE images (2D imaging without slice selection) were collected with two different echo times (NEX=1, 256x192x20, FOV=28x14 cm) as shown in Figures 6A (3D TR/TE/FA=5.2/1.2/40°) and 6B (2D TR/TE/FA=18/9/70°).

### Example 3

In this example the black blood technique was used *in vivo* by accessing the right femoral artery of two pigs under general anaesthesia. For display of the vascular system the iron oxide contrast medium was administered intravenously at a dose of 5 mg Fe/kg bodyweight. Via the femoral approach, a 5F PTA catheter was introduced into the abdominal aorta. The 40x12 mm balloon was filled with a 7.7 mM Gd solution of GdDTPA-bismethyl-amide and imaged with spoiled GRE sequences. The experiment was repeated with a 6F catheter in which the guide-wire lumen was filled with the Gd-solution. Figures 7A (3D TR/TE/FA=5.2/1.2/40°) and 7B (2D TR/TE/FA=18/9/70°) show the resulting spoiled GRE in vivo images of the abdomen of the pig. Note the bright signal intensity of both vascular system and catheter balloon in the short-echo image. With TE=9 ms only the balloon (arrow) and blood in the intraperitoneal cavity from a preceding experiment remain visible.

## Claims

1. A method of facilitating passive visualisation of an invasive device in the vasculature of a human or non-human body or in vascularised tissue in said body by generating an MR image of at least part of said body containing said device and containing a chemical blood pool contrast agent, **characterised in that** said blood pool contrast agent has been selected so as to remain in the intravascular space during the time course of the visualisation procedure.

2. A method as claimed in claim 1 **characterised in that** the difference in at least one parameter chosen from T₁, T₂ and T₂* between the blood and said device is utilised to generate image contrast between the blood and said device.

3. A method as claimed in any of claims 1 to 2 **characterised in that** said device is filled with a diamagnetic material or a paramagnetic material.

4. A method as claimed in any of claims 1 to 3 **characterised in that** said contrast agent enhances the T₁ and/or T₂* relaxation properties of the blood relative to that of said device.

5. A method as claimed in claim 4 **characterised in that** the T₁ relaxation property of the blood is enhanced relative to that of said device and wherein T₁-weighted sequences are used and said device filled with diamagnetic material so that the blood appears bright in said image, relative to said device.

6. A method as claimed in claim 4 **characterised in that** the T₂* relaxation property of the blood is enhanced relative to that of said device and wherein T₂*- weighted sequences are used and said device filled with the paramagnetic material so that said device appears bright in said image, relative to the blood.

7. A method as claimed in any of claims 1 to 6 **characterised in that** said chemical blood pool contrast agent is a magnetic iron oxide blood pool contrast agent

8. A method as claimed in any of claims 1 to 7 **characterised in that** said chemical blood pool contrast agent comprises superparamagnetic iron oxide particles having on their surfaces degraded starch and optionally a material which inhibits opsonization.

9. A method as claimed in any of claims 1 to 8 **characterised in that** said device is chosen from catheters, balloons, optical fibres, guide wires, needles, biopsy needles, electrodes, electrode leads, implants, stents and stent grafts.

10. A method as claimed in any of claims 1 to 9 **characterised in that** said device is not marked with a magnetic susceptibility agent.

## Patentansprüche

1. Verfahren zum Vereinfachen der passiven Sichtbarmachung einer invasiven Vorrichtung in der Vaskulatur eines menschlichen oder nicht-menschlichen Körpers oder in vaskularisiertem Gewebe in dem Körper durch Erzeugen eines MR-Bildes mindestens eines Teils des Körpers, der die Vorrichtung enthält und der ein chemisches Bloodpool-Kontrastmittel enthält, **dadurch gekennzeichnet, dass** das Bloodpool-Kontrastmittel derart ausgewählt wurde, dass es in dem intravaskulären Raum während des Zeitverlaufs der Sichtbarmachungsprozedur bleibt.

2. Verfahren nach Anspruch 1, **dadurch gekennzeichnet, dass** der Unterschied in mindestens einem Parameter ausgewählt aus T₁, T₂ und T₂* zwischen dem Blut und der Vorrichtung genutzt wird, um den Bildkontrast zwischen dem Blut und der Vorrichtung zu erzeugen.

3. Verfahren nach einem der Ansprüche 1 bis 2, **dadurch gekennzeichnet, dass** die Vorrichtung mit einem diamagnetischen Material oder einem paramagnetischen Material gefüllt ist.

4. Verfahren nach einem der Ansprüche 1 bis 3, **dadurch gekennzeichnet, dass** das Kontrastmittel die T₁- und/oder T₂*-Relaxationseigenschaften des Blutes relativ zu jenen der Vorrichtung verstärkt.

5. Verfahren nach Anspruch 4, **dadurch gekennzeichnet, dass** die T₁-Relaxationseigenschaft des Blutes verstärkt wird relativ zu jener der Vorrichtung, und wobei T₁-gewichtete Sequenzen verwendet werden und die Vorrichtung derart gefüllt ist mit diamagnetischem Material, dass das Blut hell in dem Bild erscheint, relativ zu der Vorrichtung.

6. Verfahren nach Anspruch 4, **dadurch gekennzeichnet, dass** die T₂*-Relaxationseigenschaft des Blutes verstärkt wird relativ zu jener der Vorrichtung, und wobei T₂*-gewichtete Sequenzen verwendet werden und die Vorrichtung gefüllt ist mit dem paramagnetischen Material derart, dass die Vorrichtung hell in dem Bild erscheint, relativ zu dem Blut.

7. Verfahren nach einem der Ansprüche 1 bis 6, **dadurch gekennzeichnet, dass** das chemische Bloodpool-Kontrastmittel ein magnetisches Eisenoxid-Bloodpool-Kontrastmittel ist.

8. Verfahren nach einem der Ansprüche 1 bis 7, **dadurch gekennzeichnet, dass** das chemische Bloodpool-Kontrastmittel superparamagnetische Eisenoxidteilchen umfasst, die auf ihren Oberflächen abgebaute Stärke und ggf. ein Material aufweisen, das die Opsonisierung inhibiert.

9. Verfahren nach einem Ansprüche 1 bis 8, **dadurch gekennzeichnet, dass** die Vorrichtung ausgewählt ist aus Kathetern, Ballonen, optischen Fasern, Führungsdrähten, Nadeln, Biopsienadeln, Elektroden, Elektrodenzuleitungen, Implantaten, Stents und Stent-grafts.

10. Verfahren nach einem der Ansprüche 1 bis 9, **dadurch gekennzeichnet, dass** die Vorrichtung nicht mit einem magnetischen Suszeptibilitätsmittel markiert ist.

## Revendications

1. Procédé destiné à faciliter la visualisation passive d'un dispositif invasif dans le système vasculaire d'un corps humain ou non humain ou dans un tissu vascularisé dans ledit corps en produisant une image de résonance RM d'au moins une partie dudit corps contenant ledit dispositif et contenant un agent de contraste chimique de regroupement de sang, **caractérisé en ce que** ledit agent de contraste de regroupement de sang a été sélectionné de manière à rester dans l'espace intravasculaire au cours de la procédure de visualisation.

2. Procédé selon la revendication 1, **caractérisé en ce que** la différence sur au moins un paramètre choisi à partir de T₁, T₂ et T₂* entre le sang et ledit dispositif est utilisée afin de produire un contraste d'image entre le sang et ledit dispositif.

3. Procédé selon l'une quelconque des revendications 1 ou 2, **caractérisé en ce que** ledit dispositif est rempli avec un matériau diamagnétique ou un matériau paramagnétique.

4. Procédé selon l'une quelconque des revendications 1 à 3, **caractérisé en ce que** ledit agent de contraste améliore les propriétés de relaxation T₁ et/ou T₂* du sang par rapport à celles du dispositif.

5. Procédé selon la revendication 4, **caractérisé en ce que** la propriété de relaxation T₁ du sang est améliorée par rapport à celle dudit dispositif et dans lequel des séquences pondérées par T₁ sont utilisées et ledit dispositif rempli avec un matériau diamagnétique de sorte que le sang paraît brillant sur ladite image, par rapport audit dispositif.

6. Procédé selon la revendication 4, **caractérisé en ce que** la propriété de relaxation T₂* du sang est améliorée par rapport à celle dudit dispositif et dans lequel des séquences pondérées par T₂* sont utilisées et ledit dispositif rempli avec le matériau paramagnétique de sorte que ledit dispositif paraît brillant sur ladite image, par rapport au sang.

7. Procédé selon l'une quelconque des revendications 1 à 6, **caractérisé en ce que** ledit agent de contraste chimique de regroupement de sang est un agent de contraste de regroupement de sang à base d'oxyde de fer magnétique.

8. Procédé selon l'une quelconque des revendications 1 à 7, **caractérisé en ce que** ledit agent de contraste chimique de regroupement de sang comprend des particules d'oxyde de fer super-paramagnétiques présentant sur leur surface, de l'amidon dégradé et, en variante, un matériau qui inhibe l'opsonisation.

9. Procédé selon l'une quelconque des revendications 1 à 8, **caractérisé en ce que** ledit dispositif est choisi à partir de cathéters, ballonnets, fibres optiques, fils de guidage, aiguilles, aiguilles de biopsie, électrodes, fils d'électrodes, implants, renforts et greffons renfort.

10. Procédé selon l'une quelconque des revendications 1 à 9, **caractérisé en ce que** l'agent n'est pas marqué par un agent de susceptibilité magnétique.
